# EUROPEAN PATENT APPLICATION

(11) **EP 4 761 479 A1**
(43) Date of publication of application: **17.06.2026**
(21) Application number: 25205660.1
(22) Date of filing: 30.09.2025
(51) Int. Cl.: H05K 7/14, H05K 7/20

(54) **SERVER EXPANSION CHASSIS AND SERVER DEVICE**

(30) Priority: 13.12.2024 CN 202411844909
(71) Applicant: Douyin Vision Co., Ltd., Beijing 100041 (CN)
(72) Inventor: Wang, Ruidong, Beijing, 100028 (CN); Fan, Hongwei, Beijing, 100028 (CN); Liu, Handa, Beijing, 100028 (CN); Zhang, Ying, Beijing, 100028 (CN); Shen, Chen, Beijing, 100028 (CN); Gui, Chenglong, Beijing, 100028 (CN); Zhao, Zhibo, Beijing, 100028 (CN); Ren, Yuanlin, Beijing, 100028 (CN); Wang, Jian, Beijing, 100028 (CN)
(74) Representative: Grünecker Patent- und Rechtsanwälte PartG mbB

(57) **Abstract**

Embodiments of the disclosure provide a server expansion chassis and a server device. The server expansion chassis includes a chassis body, a carrier board, a plurality of expansion cards, and a plurality of data interfaces. The chassis body includes an accommodating cavity and a first opening. The first opening is disposed at a front side of the chassis body and communicated with the accommodating cavity. The carrier board is disposed in the accommodating cavity adjacent to the first opening. The plurality of expansion cards are detachably coupled to the carrier board. The plurality of data interfaces are disposed at the first opening and electrically connected to the carrier board.

## Description

### FIELD

Embodiments of the present disclosure generally relate to the field of computer system architecture and, in particular, to a server expansion chassis and a server device.

### BACKGROUND

With the advancement of information technologies, a higher interconnection bandwidth is required to ensure fast data transmission among multiple devices to prevent communication delays. In some conventional Peripheral Component Interconnect Express (PCIe) expansion chassis, expansion cards are usually disposed at a rear side of the chassis. When the expansion chassis is connected to a server with front-side cable outlets, cables need to go across the entire interior of the chassis and are then connected to the server at a front side of the chassis, making it difficult to deploy the cables. In addition, when a network interface card is configured, the network interface card also needs to be placed at the rear side. The rear-placed network interface card and network optical module will affect the stability of the system due to poor heat dissipation.

### SUMMARY

In a first aspect of the present disclosure, a server expansion chassis is provided. The server expansion chassis includes: a chassis body including an accommodating cavity and a first opening, the first opening being disposed at a front side of the chassis body and communicated with the accommodating cavity; a carrier board disposed in the accommodating cavity adjacent to the first opening; a plurality of expansion cards detachably coupled to the carrier board; and a plurality of data interfaces disposed at the first opening and electrically connected to the carrier board.

In a second aspect of the present disclosure, a server device is provided. The server device includes: a server host; and the server expansion chassis of the first aspect of the present disclosure, the plurality of data interfaces of the server expansion chassis being coupled to the server host.

It should be understood that the content described in this section is not intended to identify key or essential features of the embodiments of the present disclosure, nor is it intended to limit the scope of the present disclosure. Other features of the present disclosure will be readily envisaged through the following description.

### BRIEF DESCRIPTION OF THE DRAWINGS

The above and other features, advantages and aspects of the embodiments of the present disclosure will become more apparent in combination with the drawings and with reference to the following detailed description. In the drawings, the same or similar reference symbols refer to the same or similar elements, where:
Fig. 1 shows a perspective view of a server expansion chassis according to some embodiments of the present disclosure, in which a first opening is shown;
Fig. 2 shows a perspective view of a server expansion chassis according to some embodiments of the present disclosure, in which an accommodating cavity is shown;
Fig. 3 shows a perspective view of a carrier board and an expansion card according to some embodiments of the present disclosure, in which a plurality of through holes are shown to be disposed on the carrier board;
Fig. 4 shows a perspective view of a tray assembly and a second fan module according to some embodiments of the present disclosure;
Fig. 5 shows a perspective view of a carrier board and an expansion card according to some embodiments of the present disclosure, in which a stop portion is shown to be disposed on the expansion card;
Fig. 6 shows a perspective view of a carrier board and an expansion card according to some embodiments of the present disclosure, in which the stop portion is shown to be inserted into the through hole of the carrier board;
Fig. 7 shows a right view of a server expansion chassis according to some embodiments of the present disclosure, in which an upper chamber and a lower chamber are shown;
Fig. 8 shows a perspective view of a server expansion chassis according to some embodiments of the present disclosure, in which a second opening is shown; and
Fig. 9 shows a perspective view of a liquid cooling system according to some embodiments of the present disclosure.

List of reference symbols:
10, chassis body; 100, accommodating cavity; 101, upper chamber; 102, lower chamber; 11, first opening; 12, second opening;
20, carrier board; 21, data interface; 22, through hole;
30, tray assembly; 31, tray panel; 310, limiting portion; 32, support member;
40, expansion card; 41, stop portion;
51, first fan module; 52, second fan module; 53, power module; 54, partition member; 55, air guide hood; 551, air inlet;
60, liquid cooling system; 61, liquid inlet pipe; 62, liquid return pipe; 63, liquid cooling adapter; 631, liquid inlet; 632, liquid outlet; 64, liquid guide pipe;
71, input/output module; 72, filter screen; 73, mounting bracket; 730, mounting area; 74, support frame.

### DETAILED DESCRIPTION

Embodiments of the present disclosure are described in more detail hereinafter with reference to the drawings. Although the embodiments of the present disclosure are shown in the drawings, it should be understood that the present disclosure may be implemented in various forms and should not be limited by the embodiments set forth herein. On the contrary, these embodiments are provided for a more thorough and complete understanding of the present disclosure and for a full conveyance of the scope of the present disclosure to those skilled in the art.

As used herein, the term "include/comprise" and variations thereof represent open-ended inclusions, that is, "include/comprise but not limited to". Unless otherwise stated, the term "or" represents "and/or". The term "based on" represents "at least partially based on". The terms "one example embodiment" and "one embodiment" represent "at least one example embodiment". The term "another embodiment" represents "at least one another embodiment". The terms "first", "second", and the like may refer to different or same objects.

As mentioned above, in some conventional Peripheral Component Interconnect Express (PCIe) expansion chassis, expansion cards are usually disposed at the rear side of the chassis. When the expansion chassis is connected to a server with front-side cable outlets, cables need to go across the entire interior of the chassis and are then connected to the server at the front side of the chassis, making it difficult to deploy the cables. In addition, when a network interface card is configured, the network interface card also needs to be placed at the rear side. The rear-placed network interface card and network optical module will affect the stability of the system due to poor heat dissipation.

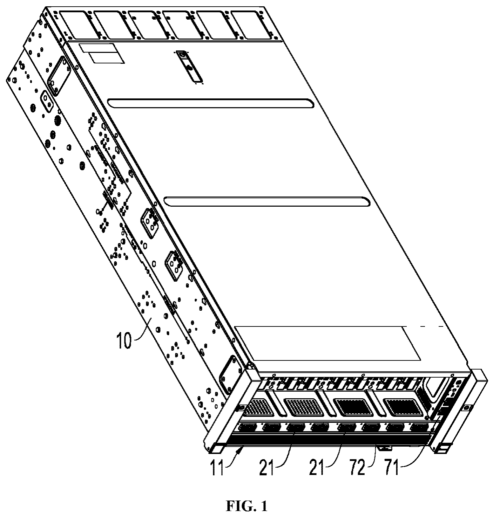

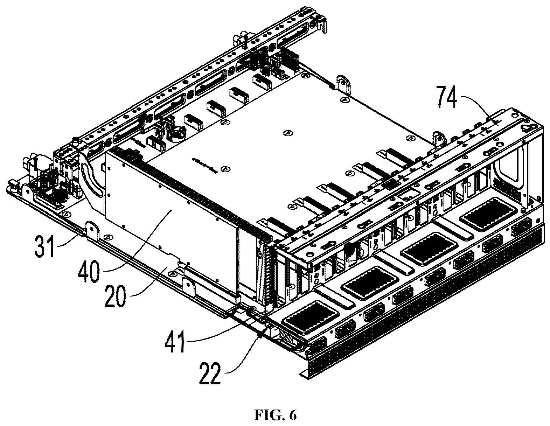

Embodiments of the present disclosure provide a server expansion chassis and a server device. The server expansion chassis includes a chassis body, a carrier board, a plurality of expansion cards, and a plurality of data interfaces. The chassis body includes an accommodating cavity and a first opening. The first opening is disposed at the front side of the chassis body and communicated with the accommodating cavity. The carrier board is disposed in the accommodating cavity adjacent to the first opening. The plurality of expansion cards are detachably coupled to the carrier board. The plurality of data interfaces are disposed at the first opening and electrically connected to the carrier board. With this arrangement, the carrier board and the plurality of expansion cards are disposed adjacent to the front side of the chassis, and the data interfaces are directly disposed at the first opening. When the expansion chassis is connected to a server host with front-side cable outlets, the server host and the data interfaces of the server expansion chassis are connected by cables outside the chassis body, without need of disposing the cables inside the chassis, making the deployment more convenient and direct. In addition, the plurality of data interfaces are disposed at the front side of the chassis, away from high-temperature heat sources at the rear side of the chassis, so that the data interfaces have better heat dissipation performance, and the stability of the system may be improved. The principles of the present disclosure are described in detail hereinafter with reference to FIG. 1 to FIG. 9.

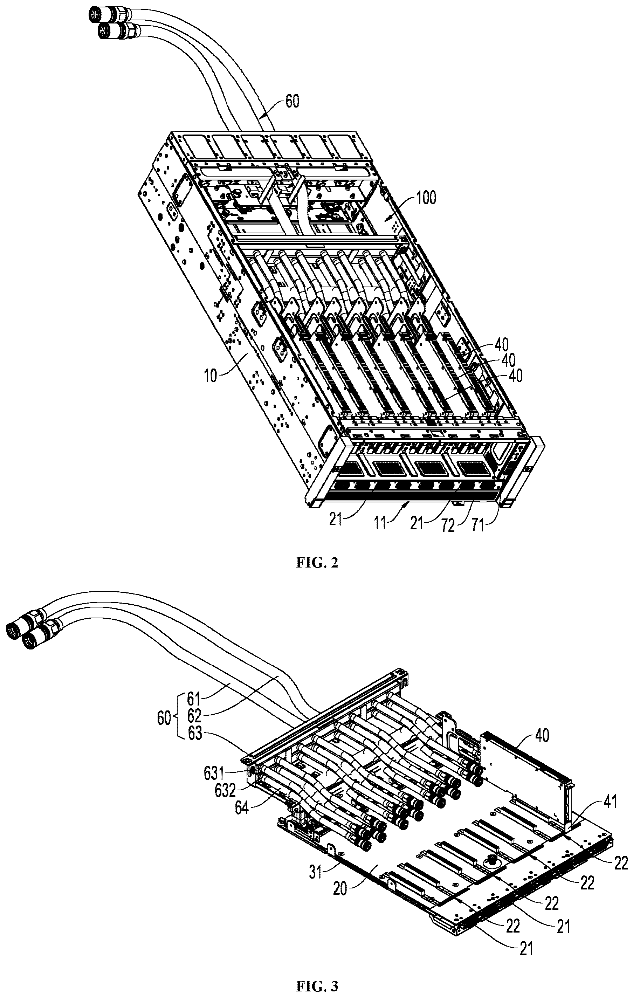

As shown in FIG. 1 and FIG. 2, the server expansion chassis may provide a computer system with more resource expansion capabilities, such as a plurality of input/output options, storage space, or network connection capabilities. The server expansion chassis includes a chassis body 10, a carrier board 20, a plurality of expansion cards 40, and a plurality of data interfaces 21.

As shown in FIG. 2, the chassis body 10 includes an accommodating cavity 100 and a first opening 11. The accommodating cavity 100 is used for installing various hardware. The first opening 11 is disposed at the front side of the chassis body 10 and communicated with the accommodating cavity 100.

The carrier board 20 is disposed inside the chassis body 10 and close to the first opening 11. Various types of slots may be disposed on the carrier board 20, and expansion cards 40 of different specifications and uses may be inserted into the slots. Here, since the carrier board 20 is adjacent to the first opening 11, the expansion cards 40 installed on the carrier board 20 are also located at a position of the chassis body 10 adjacent to the first opening 11, thereby shortening a signal transmission path from the expansion cards 40 to an external data interface. In this way, it is beneficial to reducing signal attenuation, improving a data transmission speed, and reducing the complexity of cable arrangement.

As shown in FIG. 2 and FIG. 3, the plurality of expansion cards 40 are detachably coupled to the carrier board 20. For example, the expansion cards 40 are coupled to the carrier board 20 through specific interfaces, which may realize a plug-and-play function. In addition, users may freely select and configure the type and number of expansion cards 40 according to actual needs, which may expand the scope of application of the server expansion chassis.

As an example, the expansion cards 40 may be network adapters. In this way, the plurality of expansion cards 40 may improve network performance.

As another example, the expansion cards 40 may be graphic processing units. In this way, the plurality of expansion cards 40 may accelerate image rendering tasks.

It should be understood that in other embodiments, the expansion cards 40 may also be solid state disks or processing units, and users may select the number and type of expansion cards 40 according to needs, which is not intended to be limited in the present disclosure.

As shown in FIG. 1 and FIG. 2, the plurality of data interfaces 21 are disposed at the first opening 11 and electrically connected to the carrier board 20. In some embodiments, the data interfaces 21 may be coherent direct-connect fiber optic interfaces. In this way, the data interfaces 21 may perform high-speed data transmission between the server host and the server expansion chassis, and have high bandwidth, strong anti-interference ability, and good spectral efficiency, which may simplify the network architecture.

In this way, the server host with front-side cable outlets and the server expansion chassis may be connected together by using external cables, without need of arranging the cables inside the chassis body 10. Arranging the cables on the front side of the chassis body 10 may also avoid the wire harness crossing and confusion caused by too many cables inside the chassis body 10. In addition, placing the data interfaces 21 on the front side of the chassis body 10 may avoid the high-temperature area of the chassis body 10. For example, it avoids the power module 53 and the fan module located at the rear of the chassis body 10. Therefore, the data interfaces have better heat dissipation performance, and the stability of the system may be improved.

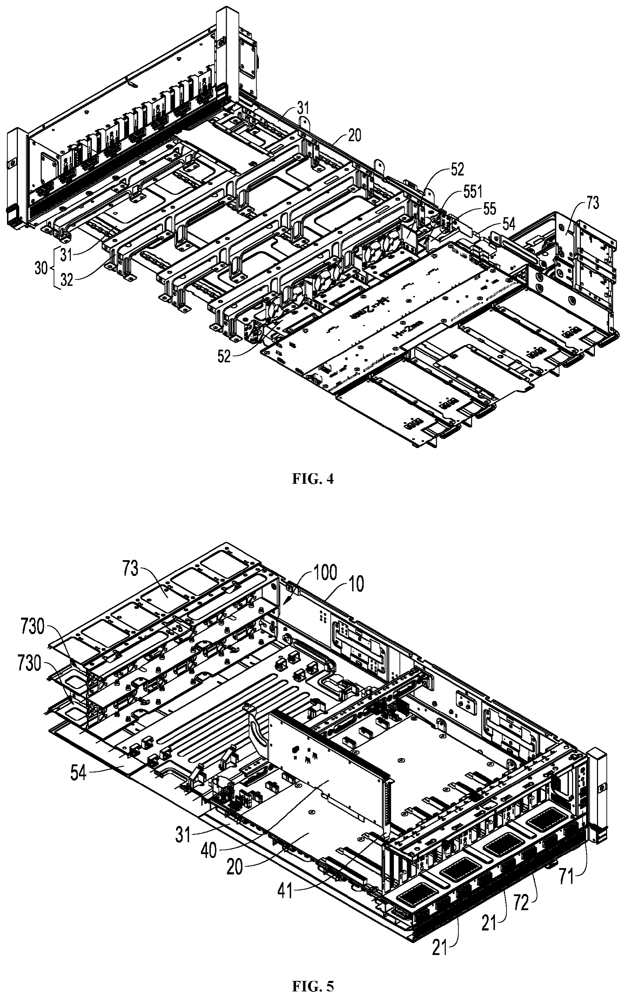

In some embodiments, as shown in FIG. 4, the server expansion chassis further includes a tray assembly 30. The tray assembly 30 is disposed in the accommodating cavity 100 and coupled to the bottom of the carrier board 20. The tray assembly 30 may provide a mounting platform for the carrier board 20, which may enhance the mechanical strength of the carrier board 20, enable it to bear the weight of the plurality of expansion cards 40 and other components installed on it, and reduce potential failures caused by vibration or external impact.

In some embodiments, as shown in FIG. 3 and FIG. 5, an end of each expansion card 40 close to the first opening 11 is provided with a stop portion 41. The stop portion 41 is coupled to the tray assembly 30, which may limit the position of the expansion card 40 and prevent it from unnecessary movement or loosening during operation. With this arrangement, the stop portion 41 may enable the expansion card 40 to be in good contact with the carrier board 20, and reduce poor circuit contact caused by the loosening of the expansion card 40.

In some embodiments, as shown in FIG. 5, a support frame 74 may be disposed in the accommodating cavity 100. The support frame 74 is installed inside the chassis body 10 and may abut against the plurality of expansion cards 40. In this way, the support frame 74 may provide an additional support position for the expansion cards 40, thereby avoiding the expansion cards 40 from being deformed or damaged due to excessive pressure. In addition, the support frame 74 may keep the plurality of expansion cards 40 disposed in parallel and increase the stability of the expansion cards 40. When a new expansion card 40 needs to be added, a technician only needs to insert the expansion card 40 into a card slot on the carrier board 20 until the stop portion 41 contacts the tray assembly 30 and/or the support frame 74.

In some embodiments, as shown in FIG. 3, FIG. 5, and FIG. 6, the carrier board 20 is provided with a plurality of through holes 22 spaced apart from each other, and the plurality of through holes 22 are in one-to-one correspondence with the stop portions 41 on the expansion cards 40. Here, the stop portions 41 may be, for example, blocking pieces, and the blocking pieces may penetrate through the corresponding through holes 22 on the carrier board 20 and contact the tray assembly 30 located below. In this way, the stop portions 41 may be tightly connected to the tray assembly 30, which may prevent the expansion cards 40 from being displaced or loosened during operation, thereby improving the stability and efficiency of data transmission.

It should be understood that the carrier board 20 may arrange circuits in areas other than the plurality of through holes 22 to realize data transmission with the plurality of data interfaces 21.

In some embodiments, as shown in FIG. 4 to FIG. 7, the tray assembly 30 includes a tray panel 31 and a support member 32. The tray panel 31 may provide a mounting plane for the carrier board 20. A plurality of limiting portions 310 may be disposed on the tray panel 31, and the plurality of limiting portions 310 may be connected to the stop portions 41 of the plurality of expansion cards 40 in a one-to-one correspondence. In this way, the tray panel 31 may fix the positions of the plurality of expansion cards 40 and prevent them from unnecessary movement or loosening in the chassis.

As an example, the limiting portions 310 may be limiting grooves, and end portions of the stop portions 41 may be inserted into the limiting grooves, thereby limiting the positions of the stop portions 41.

As another example, the limiting portions 310 may be limiting steps, and the end portions of the stop portions 41 may abut against the limiting steps, thereby limiting the positions of the stop portions 41.

It should be understood that in other embodiments, a plurality of structures matched with the stop portions 41 may also be formed on the tray panel 31 by a stamping and bending process, and then the stop portions 41 and the limiting portions 310 are connected together by pins or screws. The present disclosure is not intended to limit the specific structural form of the limiting portions.

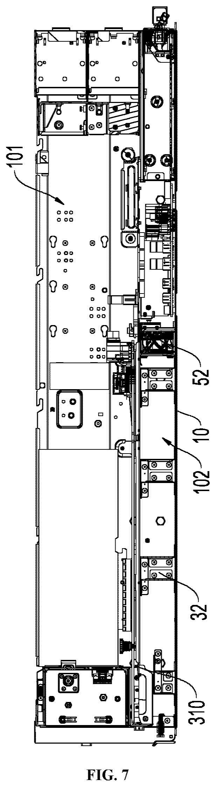

As shown in FIG. 4 and FIG. 7, the support member 32 is disposed on a side of the tray panel 31 away from the carrier board 20 and coupled to the tray panel 31. There may be a plurality of support members 32, and the plurality of support members 32 may fix the tray panel 31 in the chassis body 10 and keep a certain distance between the tray panel 31 and the bottom surface of the chassis body 10. In this way, an area for arranging cables or ventilation may be formed on the side of the tray panel 31 away from the carrier board 20, so as to make rational use of the space inside the chassis body 10.

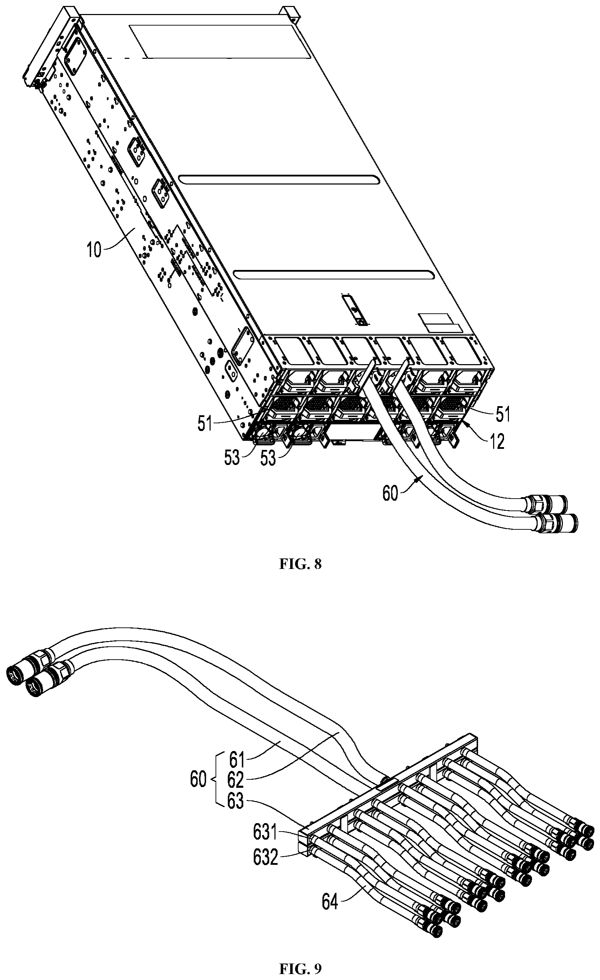

In some embodiments, as shown in FIG. 8, the chassis body 10 further includes a second opening 12. The second opening 12 is disposed at the rear side of the chassis body 10 and communicated with the accommodating cavity 100. On this basis, the server expansion chassis further includes a first fan module 51 and a power module 53. The first fan module 51 and the power module 53 are disposed at the second opening 12, the first fan module 51 is located above the power module 53, and the power module 53 is disposed below the first fan module 51.

In this way, the first fan module 51 and the power module 53, as high-heat-generating units, are disposed separately from the plurality of expansion cards 40 and the carrier board 20, which may avoid the problem of excessive heat concentration. By placing the first fan module 51 and the power module 53 at the second opening 12 at the rear side of the chassis and separating them from the expansion cards 40 and the carrier board 20, the heat distribution between various components may be made more even, and the risk caused by local overheating may be reduced, thereby improving the stability of the system during operation.

In addition, the height of the first fan module 51 corresponds to the plurality of expansion cards 40 and the carrier board 20. When the first fan module 51 is in operation, the airflow may be directly aimed at the surfaces of the plurality of expansion cards 40 and the carrier board 20, thereby promoting rapid heat dissipation. During operation, the first fan module 51 draws air from the first opening 11, and after passing through the surfaces of the expansion cards 40 and the carrier board 20, the air is discharged out of the chassis body 10 through the second opening 12, thereby discharging the heat out of the chassis body 10.

As shown in FIG. 8, the power module 53 is disposed below the first fan module 51, which may not only make full use of the limited space resources at the second opening 12, but also enable the power module 53 to be well cooled, preventing the heat generated by it from affecting the expansion cards 40 and the carrier board 20 above in the reverse direction.

In some embodiments, as shown in FIG. 7, the server expansion chassis further includes a partition member 54. The partition member 54 is disposed above the power module 53 and corresponds to the tray panel 31, and the partition member 54 and the tray panel 31 divide the accommodating cavity 100 into an upper chamber 101 and a lower chamber 102. In this way, the partition member 54 and the tray panel 31 may enable the upper chamber 101 and the lower chamber 102 to form two independent air flow channels.

As shown in FIG. 7, the carrier board 20 and the plurality of expansion cards 40 are disposed in the upper chamber 101, and the heat dissipated by the carrier board 20 and the plurality of expansion cards 40 during operation may be discharged through the air flowing in the upper chamber 101. The first fan module 51 is installed at the rear side of the chassis body 10 and corresponds to the upper chamber 101. The first fan module 51 may promote the air to flow into the interior of the chassis body 10 from the first opening 11, and the air passes through the surfaces of various components in the upper chamber 101 and is then discharged through the second opening 12.

The power module 53 is installed in the lower chamber 102. Since the power module 53 is a main heat source, separating it from the upper chamber 101 may avoid the adverse influence of the heat generated by it on other sensitive electronic components. In addition, the heat dissipated by the power module 53 may be discharged along with the air flowing in the lower chamber 102.

In some embodiments, as shown in FIG. 4 and FIG. 7, the server expansion chassis further includes a second fan module 52. The second fan module 52 is disposed in the lower chamber 102 and coupled to the chassis body 10. The second fan module 52 is dedicated to the air circulation in the lower chamber 102, and may discharge the heat generated by the power module 53 during operation. When the second fan module 52 is in operation, air may be sucked from the first opening 11 on the front side of the chassis body 10, and after passing through the surface of the power module 53, the air is discharged through the second opening 12 on the rear side of the chassis body 10. In this way, the temperature in the lower chamber 102 may be reduced, and the working efficiency and service life of the power module 53 may be improved.

In some embodiments, as shown in FIG. 4, the server expansion chassis further includes an air guide hood 55. The air guide hood 55 surrounds at least a portion of the power module 53 and includes an air inlet 551 and an air outlet that are disposed opposite to each other. The air inlet 551 corresponds to the first opening 11, and the air outlet corresponds to the second opening 12. The air in the lower chamber 102 may enter the interior of the air guide hood 55 via the air inlet 551 and then flow towards the second opening 12 via the air outlet, which may form an efficient airflow path, so that the surface of the power module 53 may be fully cooled, and the heat dissipation effect may be greatly improved.

When the second fan module 52 is working, the second fan module 52 will suck cold air from the first opening 11, and the cold air will enter the lower chamber 102. Due to the presence of the air guide hood 55, the cold air flows towards the surface of the power module 53. The hot air after heat exchange may be discharged along the air outlet of the air guide hood 55 and out of the chassis body 10 via the second opening 12. In this way, heat may be prevented from accumulating in the lower chamber 102, and the power module 53 may be kept at a relatively low working temperature, thereby improving the efficiency and service life of the power module 53.

In some embodiments, as shown in FIG. 5, the server expansion chassis further includes a mounting bracket 73. The mounting bracket 73 is disposed at the second opening 12 and includes a plurality of mounting areas 730 for fixing the first fan module 51 and the power module 53. In this way, the mounting bracket 73 may firmly fix the first fan module 51 and the power module 53, and prevent them from being displaced or loosened due to vibration or external force, thereby ensuring the reliability and safety in long-term operation. In addition, the mounting bracket 73 may make the installation and disassembly process of the first fan module 51 and the power module 53 easier and faster. The technician may add or remove components without destroying the overall structure of the chassis body 10 to perform necessary upgrade or maintenance work.

In some embodiments, the mounting bracket 73 may further provide greater flexibility for the technician, and the number of the first fan modules 51 and the number of the power modules 53 may be adjusted according to actual needs. For example, when the power of the plurality of expansion cards 40 and the power of the carrier board 20 are relatively high, the number of the first fan modules 51 and the number of the power modules 53 may be increased to meet higher heat dissipation and power supply requirements. More first fan modules 51 may provide stronger airflow, so that the expansion cards 40 and the carrier board 20 may be kept at a suitable working temperature under high load. The additional power module 53 may provide more sufficient power support, avoiding performance bottlenecks or system instability caused by insufficient power.

In the case that the power of the plurality of expansion cards 40 and the power of the carrier board 20 are relatively low, the technician may choose to reduce the number of the first fan modules 51 and the number of the power modules 53 to reduce unnecessary energy consumption and operating costs.

By flexibly adjusting the number of the first fan modules 51 and the number of the power modules 53, the server expansion chassis may achieve an optimal balance between performance and energy efficiency in different application scenarios, ensuring that the system is always in an efficient and stable operation state.

In some embodiments, as shown in FIG. 1 and FIG. 2, the server expansion chassis further includes an input/output module 71 (I/O module). The input/output module 71 is disposed at the first opening 11 and electrically connected to the carrier board 20. The input/output module 71 performs functions such as data transmission, signal exchange, and power management. By arranging it at the first opening 11, it may facilitate the access and management of cables.

In some embodiments, as shown in FIG. 1 and FIG. 2, the server expansion chassis further includes a filter screen 72. The filter screen 72 is disposed at the first opening 11 and coupled to the chassis body 10. In this way, the filter screen 72 may prevent sundries carried in the process of air flowing from entering the interior of the chassis body 10 through the first opening 11, thereby protecting the working environment of internal electronic components. In addition, the filter screen 72 may also improve electrical safety and prevent the technician from accidentally contacting internal sensitive components during operation or maintenance.

When the server expansion chassis is in operation, the filter screen 72 may intercept dust, fibers, and other tiny particles, preventing them from entering the interior of the chassis along with the airflow and adhering to the expansion cards 40, the carrier board 20, or other components. If these sundries accumulate for a long time, it may lead to a decrease in heat dissipation efficiency, an increase in the risk of overheating, and even serious failures such as short circuits. By installing the filter screen 72, the air entering the chassis body 10 may be relatively clean, and the stability and cleanliness of the internal environment may be maintained, thereby prolonging the service life of the electronic components and the reliability of the system.

In addition, during daily maintenance or adjustment, the technician needs to perform operations such as cable connection or disconnection at the first opening 11. The filter screen 72 may provide a physical barrier to prevent the technician from inadvertently touching the internal live electronic components, thereby avoiding the danger of electric shock or damage to sensitive circuits.

In some embodiments, as shown in FIG. 2, FIG. 3, and FIG. 9, the server expansion chassis further includes a liquid cooling system 60. The liquid cooling system 60 is disposed in the accommodating cavity 100 and coupled to the plurality of expansion cards 40. The liquid cooling system 60 may take away the heat generated by the electronic components inside the chassis through the circulating flow of the cooling liquid, so that the plurality of expansion cards 40 may be kept at a suitable working temperature in the high-performance working state. The liquid cooling system 60 has higher cooling efficiency and may meet the heat dissipation requirements of high-performance servers.

In some embodiments, as shown in FIG. 9, the liquid cooling system 60 includes a liquid inlet pipe 61, a liquid return pipe 62, and a liquid cooling adapter 63. The liquid cooling adapter 63 is communicated with the liquid inlet pipe 61 and the liquid return pipe 62, and the liquid cooling adapter 63 includes a plurality of liquid inlets 631 and a plurality of liquid outlets 632, and the plurality of liquid inlets 631 and the plurality of liquid outlets 632 are coupled to the plurality of expansion cards 40 in a one-to-one correspondence.

When the liquid cooling system 60 is in operation, the cooling liquid is pumped into the liquid cooling adapter 63 by an external cooling device (such as a chiller) through the liquid inlet pipe 61. The interior of the liquid cooling adapter 63 is provided with flow channels, which may distribute the cooling liquid into the plurality of liquid outlets 632, and each liquid outlet 632 is connected to a cold plate built in an expansion card 40. When the cooling liquid flows through the cold plate, it may absorb and take away the heat generated by the expansion card 40. In this process, the temperature of the cooling liquid gradually rises from a low temperature, and a large amount of heat energy is taken away.

Subsequently, the cooling liquid that has absorbed the heat flows into the corresponding liquid inlet 631 of the liquid cooling adapter 63 and then enters the liquid return pipe 62. The liquid return pipe 62 guides the heated cooling liquid back to the external cooling device, and the heat is dissipated to the environment at the external cooling device through a radiator or other cooling means, so that the temperature of the cooling liquid is reduced again. After the temperature reduction treatment, the cooling liquid is pumped back to the liquid inlet pipe 61 again to start a new round of circulation. In the whole process, the cooling liquid is always in a closed loop, which avoids direct contact with the electrical components and may ensure efficient heat transfer at the same time.

In some embodiments, as shown in FIG. 2, FIG. 3, and FIG. 9, the liquid cooling adapter is disposed on a side of the plurality of expansion cards 40 away from the first opening 11, and the plurality of liquid inlets 631 and the plurality of liquid outlets 632 are disposed on a side of the liquid cooling adapter 63 facing the plurality of expansion cards 40. In this way, the plurality of liquid inlets 631 and the plurality of liquid outlets 632 may directly face the expansion cards 40, and the liquid inlets 631 and the liquid outlets 632 may be connected to the expansion cards 40 through liquid guide pipes 64. Here, the liquid guide pipes 64 may be disposed close to a straight line without being zigzagged inside the chassis body 10, which may not only save the space inside the chassis body 10, but also improve the flow efficiency of the cooling liquid.

In a second aspect of the present disclosure, a server device is provided. The server device includes a server host and any of the server expansion chassis described above. The plurality of data interfaces 21 of the server expansion chassis are coupled to the server host.

In the server expansion chassis of the server device, the chassis body 10 includes an accommodating cavity 100 and a first opening 11. The first opening 11 is disposed at the front side of the chassis body 10 and communicated with the accommodating cavity 100. The carrier board 20 is disposed in the accommodating cavity 100 adjacent to the first opening 11. The plurality of expansion cards 40 are detachably coupled to the carrier board 20. The plurality of data interfaces 21 are disposed at the first opening 11 and electrically connected to the carrier board 20. With this arrangement, the carrier board 20 and the plurality of expansion cards 40 are disposed adjacent to the front side of the chassis, and the data interfaces 21 are directly disposed at the first opening 11. When the expansion chassis is connected to the server host with front-side cable outlets, the server host and the data interfaces 21 are connected by cables outside the chassis, without need of disposing the cables inside the chassis, making the deployment more convenient and direct. In addition, the plurality of data interfaces 21 are disposed on the front side of the chassis body 10, away from high-temperature heat sources on the rear side of the chassis, so that the data interfaces have better heat dissipation performance, and the stability of the system may be improved.

The embodiments of the present disclosure are further reflected in the following examples.

Example 1. A server expansion chassis, including:
a chassis body including an accommodating cavity and a first opening, the first opening being disposed at a front side of the chassis body and communicated with the accommodating cavity;
a carrier board disposed in the accommodating cavity adjacent to the first opening;
a plurality of expansion cards detachably coupled to the carrier board; and
a plurality of data interfaces disposed at the first opening and electrically connected to the carrier board.
Example 2. The server expansion chassis of Example 1, further including:
a tray assembly disposed in the accommodating cavity and coupled to a bottom of the carrier board.

Example 3. The server expansion chassis of Example 2, where an end of each expansion card close to the first opening is provided with a stop portion, and the stop portion is coupled to the tray assembly to limit the expansion card.

Example 4. The server expansion chassis of Example 3, where the carrier board includes a plurality of through holes spaced apart from each other, and the stop portions of the plurality of expansion cards respectively penetrate through the plurality of through holes in a one-to-one correspondence to be coupled to the tray assembly.

Example 5. The server expansion chassis of Example 4, where the tray assembly includes a tray panel, a plurality of limiting portions are disposed on the tray panel, and the plurality of limiting portions are respectively coupled to the stop portions of the plurality of expansion cards.

Example 6. The server expansion chassis of Example 5, where the chassis body further includes a second opening, the second opening is disposed at a rear side of the chassis body and communicated with the accommodating cavity, and the server expansion chassis further includes:
a first fan module disposed at the second opening; and
a power module disposed at the second opening and below the first fan module.

Example 7. The server expansion chassis of Example 6, further including:
a partition member disposed above the power module and corresponding to the tray panel, the partition member and the tray panel dividing the accommodating cavity into an upper chamber and a lower chamber, the carrier board and the plurality of expansion cards being disposed in the upper chamber, and the power module being disposed in the lower chamber.

Example 8. The server expansion chassis of Example 7, where the first fan module corresponds to the upper chamber, and the server expansion chassis further includes:
a second fan module, disposed in the lower chamber and coupled to the chassis body.

Example 9. The server expansion chassis of Example 8, further including:
an air guide hood surrounding at least a portion of the power module and including an air inlet and an air outlet that are disposed opposite to each other, the air inlet corresponding to the first opening, the air outlet corresponding to the second opening, and air in the lower chamber entering the air guide hood via the air inlet and flowing towards the second opening via the air outlet.

Example 10. The server expansion chassis of any of Examples 5 to 9, where the tray assembly further includes:
a support member, disposed on a side of the tray panel away from the carrier board and coupled to the tray panel.

Example 11. The server expansion chassis of any of Examples 1 to 9, further including:
a liquid cooling system, disposed in the accommodating cavity and coupled to the plurality of expansion cards.

Example 12. The server expansion chassis of Example 11, where the liquid cooling system includes:
a liquid inlet pipe and a liquid return pipe; and
a liquid cooling adapter communicated with the liquid inlet pipe and the liquid return pipe, and including a plurality of liquid inlets and a plurality of liquid outlets, the plurality of liquid inlets and the plurality of liquid outlets being coupled to the plurality of expansion cards in a one-to-one correspondence.

Example 13. The server expansion chassis of Example 12, where the liquid cooling adapter is disposed on a side of the plurality of expansion cards away from the first opening, and the plurality of liquid inlets and the plurality of liquid outlets are disposed on a side of the liquid cooling adapter facing the plurality of expansion cards.

Example 14. The server expansion chassis of any of Examples 1 to 9, where the data interfaces include a coherent direct-connect fiber optic interface.

Example 15. The server expansion chassis of any of Examples 1 to 9, further including:
an input/output module disposed at the first opening and electrically connected to the carrier board; and/or
a filter screen disposed at the first opening and coupled to the chassis body.

Example 16. The server expansion chassis of any of Examples 6 to 9, further including:
a mounting bracket, disposed at the second opening and including a plurality of mounting areas for fixing the first fan module and the power module.

Example 17. A server device, including:
a server host; and
the server expansion chassis of any of Examples 1 to 16, the plurality of data interfaces of the server expansion chassis being coupled to the server host.

The embodiments of the present disclosure have been described above, and the above description is exemplary, non-exhaustive, and not limited to the disclosed embodiments. Without departing from the scope of the described embodiments, many modifications and changes will be apparent to those of ordinary skill in the art. The choice of terms used herein is intended to best explain the principles, practical applications, or technical improvements to the market of the embodiments, or to enable other ordinary skilled in the art to understand the embodiments disclosed herein.

## Claims

1. A server expansion chassis, comprising:
a chassis body (10) comprising an accommodating cavity (100) and a first opening (11), the first opening (11) being disposed at a front side of the chassis body (10) and communicated with the accommodating cavity (100);
a carrier board (20) disposed in the accommodating cavity (100) adjacent to the first opening (11);
a plurality of expansion cards (40) detachably coupled to the carrier board (20); and
a plurality of data interfaces (21) disposed at the first opening (11) and electrically connected to the carrier board (20).

2. The server expansion chassis of claim 1, further comprising:
a tray assembly (30) disposed in the accommodating cavity (100) and coupled to a bottom of the carrier board (20).

3. The server expansion chassis of claim 2, wherein an end of each expansion card (40) close to the first opening (11) is provided with a stop portion (41), and the stop portion (41) is coupled to the tray assembly (30) to limit the expansion card (40).

4. The server expansion chassis of claim 3, wherein the carrier board (20) comprises a plurality of through holes (22) spaced apart from each other, and the stop portions (41) of the plurality of expansion cards (40) respectively penetrate through the plurality of through holes (22) in a one-to-one correspondence to be coupled to the tray assembly (30).

5. The server expansion chassis of claim 4, wherein the tray assembly (30) comprises a tray panel (31) provided with a plurality of limiting portions (310), and the plurality of limiting portions (310) are respectively coupled to the stop portions (41) of the plurality of expansion cards (40).

6. The server expansion chassis of claim 5, wherein the chassis body (10) further comprises a second opening (12), the second opening (12) is disposed at a rear side of the chassis body (10) and communicated with the accommodating cavity (100), and the server expansion chassis further comprises:
a first fan module (51) disposed at the second opening (12); and
a power module (53) disposed at the second opening (12) and below the first fan module (51).

7. The server expansion chassis of claim 6, further comprising:
a partition member (54) disposed above the power module (53) and corresponding to the tray panel (31), the partition member (54) and the tray panel (31) dividing the accommodating cavity (100) into an upper chamber (101) and a lower chamber (102), the carrier board (20) and the plurality of expansion cards (40) being disposed in the upper chamber (101), and the power module (53) being disposed in the lower chamber (102).

8. The server expansion chassis of claim 7, wherein the first fan module (51) corresponds to the upper chamber (101), and the server expansion chassis further comprises:
a second fan module (52) disposed in the lower chamber (102) and coupled to the chassis body (10).

9. The server expansion chassis of claim 8, further comprising:
an air guide hood (55) surrounding at least a portion of the power module (53) and comprising an air inlet (551) and an air outlet that are disposed opposite to each other, the air inlet (551) corresponding to the first opening (11), the air outlet corresponding to the second opening (12), and air in the lower chamber (102) entering the air guide hood (55) via the air inlet (551) and flowing towards the second opening (12) via the air outlet.

10. The server expansion chassis of any of claims 5 to 9, wherein the tray assembly (30) further comprises:
a support member (32) disposed on a side of the tray panel (31) away from the carrier board (20) and coupled to the tray panel (31).

11. The server expansion chassis of any of claims 1 to 9, further comprising:
a liquid cooling system (60) disposed in the accommodating cavity (100) and coupled to the plurality of expansion cards (40), wherein the liquid cooling system (60) comprises:
a liquid inlet pipe (61) and a liquid return pipe (62); and
a liquid cooling adapter (63), communicated with the liquid inlet pipe (61) and the liquid return pipe (62), and comprising a plurality of liquid inlets (631) and a plurality of liquid outlets (632), the plurality of liquid inlets (631) and the plurality of liquid outlets (632) being coupled to the plurality of expansion cards (40) in a one-to-one correspondence.

12. The server expansion chassis of claim 11, wherein the liquid cooling adapter (63) is disposed on a side of the plurality of expansion cards (40) away from the first opening (11), and the plurality of liquid inlets (631) and the plurality of liquid outlets (632) are disposed on a side of the liquid cooling adapter (63) facing the plurality of expansion cards (40).

13. The server expansion chassis of any of claims 1 to 9, further comprising:
an input/output module (71) disposed at the first opening (11) and electrically connected to the carrier board (20); and/or
a filter screen (72) disposed at the first opening (11) and coupled to the chassis body (10).

14. The server expansion chassis of any of claims 6 to 9, further comprising:
a mounting bracket (73) disposed at the second opening (12) and comprising a plurality of mounting areas (730) for fixing the first fan module (51) and the power module (53).

15. A server device, comprising:
a server host; and
the server expansion chassis of any of claims 1 to 14, the plurality of data interfaces (21) of the server expansion chassis being coupled to the server host.
